# EUROPEAN PATENT SPECIFICATION

(11) **EP 3 392 901 B1**
(45) Date of publication and mention of the grant of the patent: **08.07.2020**
(21) Application number: 18171192.0
(22) Date of filing: 06.08.2007
(51) Int. Cl.: H01J 45/00, H01L 35/00, H02S 10/30

(54) **CONVERSION OF THERMAL ENERGY TO ELECTRIC ENERGY**
UMWANDLUNG VON THERMISCHER ENERGIE IN ELEKTRISCHE ENERGIE
CONVERSION D'ÉNERGIE THERMIQUE EN ÉNERGIE ÉLECTRIQUE

(30) Priority: 07.08.2006 US 500062
(43) Date of publication of application: 24.10.2018
(62) Divisional of application: 16168800.7
(73) Proprietor: MTPV Power Corporation, Austin, TX 78729 (US)
(72) Inventor: Hagelstein, Peter, Carlisle, Massachusetts 01741 (US); Wu, Dennis, Cambridge, Massachusetts 02139 (US)
(74) Representative: Hamilton, Alistair

(56) References cited:
- WO-A1-99/13562
- US-A- 6 084 173
- US-A1- 2006 016 471
- HAGELSTEIN P L ET AL: "Thermal to Electric Conversion with a Novel Quantum-Coupled Converter", INTERNET CITATION, November 2006 (2006-11), pages 34-1, XP002499460, Retrieved from the Internet: URL:http://www.rle.mit.edu/media/pr148/34. pdf [retrieved on 2006-11-01]
- DIMATTEO R S ET AL: "Micron-gap thermophotovoltaics (MTPV)", THERMOPHOTOVOLTAIC GENERATION OF ELECTRICITY : FIFTH CONFERENCE ON THERMOPHOTOVOLTAIC GENERATION OF ELECTRICITY, ROME, ITALY, 16 - 19 SEPTEMBER 2002, MELVILLE, NY : AMERICAN INST. OF PHYSICS, no. 653, 16 September 2002 (2002-09-16), pages 232-240, XP002499461, DOI: 10.1063/1.1539379 ISBN: 978-0-7354-0113-6
- DIMATTEO R S ET AL: "Enhanced photogeneration of carriers in a semiconductor via coupling across a nonisothermal nanoscale vacuum gap", APPLIED PHYSICS LETTERS, A I P PUBLISHING LLC, US, vol. 79, no. 12, 17 September 2001 (2001-09-17), pages 1894-1896, XP012028939, ISSN: 0003-6951, DOI: 10.1063/1.1400762
- WU D ET AL: "Quantum-coupled single-electron thermal to electric conversion scheme", JOURNAL OF APPLIED PHYSICS, AMERICAN INSTITUTE OF PHYSICS, US, vol. 106, no. 9, 13 November 2009 (2009-11-13), pages 94315-94315, XP012127841, ISSN: 0021-8979, DOI: 10.1063/1.3257402

## Description

The present invention relates generally to the conversion of thermal energy to electric energy, being more particularly concerned with such conversion as effected by gap-separated juxtaposed hot-side radiator and cold-side charged carrier converter structures.

### Background of Invention

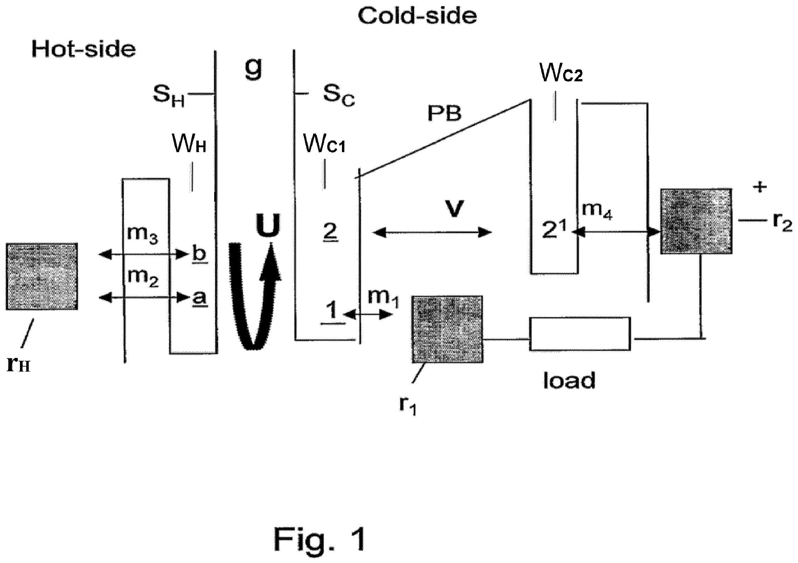

Spurred by the initial proposal to effect such conversion using a thermo-photovoltaic approach (U.S. Patent No. 6,084,173, issued July 4, 2000 to Robert DiMatteo), we have been exploring the possibility of a coherent excitation transfer at such gaps that can produce a further increase in the throughput power. This led us to the theoretical proposal of developing a single charge carrier converter in which the excitation may be transferred very close to the gaps, as described in our Massachusetts Institute of Technology Research Laboratory for Electronics internal report (RLE 148 of September, 2005) entitled "Thermal to Electric Conversion based on a Quantum-Coupling Scheme". Since this is pertinent to the present invention, its basic scheme will hereinafter be described in connection with Figure 1.

While this provided an idealized outline of possible operation, it was not, however, until an unexpected breakthrough occurred quite recently that opened the door to a practically implementable device. That breakthrough resulted in a novel combination of coherent excitation transfer through electrostatic coupling between a relatively hot-side surface and a small-gap-separated juxtaposed cold- side converter surface, wherein the latter is of a novel single-carrier cold side converter construction. The DiMatteo proposal suggests that the gap be a vacuum gap; but what is important is that his gap should not comprise a solid or liquid. It may be a gas, and even more preferably, it could be a diluted gas with the mean-free-path longer than the gap separation.

The implementation of practical devices through fabrication by now well-known solid-state chip manufacturing technologies is now achievable, promising thermal-to- electric converter arrays of this character offering high power potential.

### Objects of Invention

It is thus a primary object of the invention to provide a new and improved thermal-to-electric energy conversion method and novel apparatus or device structure utilizing the same, embodying an improved hot surface and a juxtaposed relatively cold converter surface separated by a small gap.

A further object is to provide such an apparatus employing novel excitation transfer through electrostatic coupling between the relatively hot and cold surfaces together with a new single-carrier cold-side converter chip-like structure.

Still another object is to provide novel chip arrays of such structures.

Other and further objects will be described hereinafter and will be more particularly pointed out in connection with the appended claims.

In summary, from one of its viewpoints, the invention embraces a method of converting thermal to electric energy, that comprises, juxtaposing relatively cold-side conversion and relatively hot-side surfaces separated by a small gap; providing lower state electrons on or near the cold surface; Coulomb-coupling the lower state electrons to charges on the hot surface; transferring energy from the hot-side surface to said cold-side surface lower state electrons to excite them to a higher state; collecting the higher state electrons at or near the cold surface to generate a higher potential; and extracting the converted electric energy in response to said higher potential.

In its structure or device aspect, the invention embodies in a thermal-to-electric conversion apparatus, relatively hot and cold juxtaposed surfaces separated by a small gas or vacuum gap, the cold surface providing a chip array of single charge carrier converter elements, and the hot surface electrostatically transferring excitation energy to the opposing cold surface converter elements across the gap through Coulomb electrostatic coupling interaction.

From a first aspect, the invention provides a converter having a first-side surface (SH) juxtaposed to a second-side structure (SC) separated by a gap (g), the first-side surface having electrons for transferring excitation energy across the gap, the second-side structure comprising at least one second-side converter element, each second-side converter element comprising at least one carrier supplied from at least one first second-side reservoir to at least one first second-side quantum state element being promoted from a first energy level to a second energy level by the transferred excitation energy, characterised in that the excitation energy is transferred by electrostatic coupling.

The hot side element may comprise a simple surface. The simple surface is typically selected from the group consisting of consisting of metal, semi-metal, semiconductor, and insulator.

The hot side element may comprise one or more hot side quantum wells with one or more excited energy levels supplied with one or more excited carriers by one or more hot side reservoirs.

The one or more cold side carriers may be selected from the group consisting of electrons and holes.

In operation, only one cold side carrier is typically promoted at a time.

The one or more promoted cold side carriers that tunnel through one or more cold side potential barriers may be received by one or more second cold side reservoirs at elevated voltage. The one or more promoted cold side carriers may tunnel through one or more cold side potential barriers to one or more second cold side quantum wells connected to one or more second cold side reservoirs at elevated voltage. The one or more second cold side reservoirs may be connected to the one or more first cold side reservoirs through one or more electrical loads.

The one or more first and/or second cold side quantum wells is typically selected from the group consisting of dots, cylinders, wires, quantum well sheets, molecules, rectangular boxes and bar elements.

The one or more cold side converter elements may be connected by a chip-integrated network of conductors. The conductors at the inputs of the one or more first cold side reservoirs may be commonly connected to first sides of the one or more electrical loads and the outputs of the one or more second cold side reservoirs are commonly connected to second sides of the one or more electrical loads.

Preferred designs and embodiments, including a best mode design, are hereinafter more fully presented.

### Drawings

The invention will now be described in connection with the accompanying drawings, the previously mentioned Figure 1 of which is a basic schematic diagram of an idealized conception underlying the invention;
Figure 2 is an expanded isometric schematic view of a preferred device for practicing the methodology of the invention embodying solid state conversion arrays as implementation;
Figure 3 is a similar diagram of such an array of the novel thermal-to-electric converter elements of the type shown in Figure 2; and
Figures 4 and 5 are respective load power density and efficiency of performance graphs attainable with such an embodiment of the invention.

### Description of Preferred Embodiment (s)

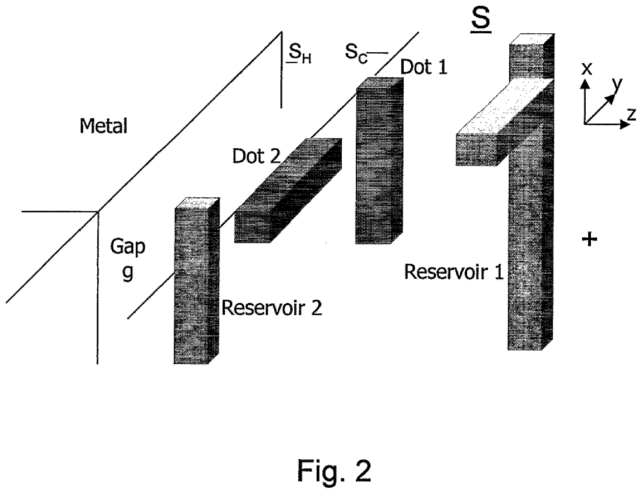

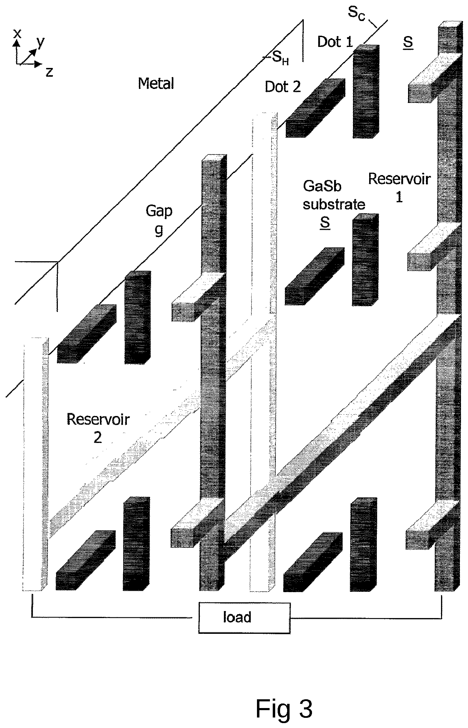

Turning first to the roadmap of our said Figure 1, this involves an idealized theoretical explanatory scheme consisting of a hot-side surface S_{H} and a juxtaposed cold- side carrier charge-to-electricity converter surface S_{C} separated by a small vacuum gap g. On the cold side, there is schematically shown a first quantum well W_{C1} having a lower electron potential level 1 and an upper level 2 and wherein an electron is introduced or supplied into the lower level or state 1 from a source of electrons called a reservoir r₁, which may be at relative ground potential. As later explained, in practical implementation, the well W_{C1} may be inherently provided in a quantum dot, such as an appropriate semi-conductor dot, and the electron reservoir r₁ may be a conductor of a conducting network interconnecting such dots in an array or matrix of dots distributed along the cold-side S_{C} as later more fully described in connection with the embodiments of Figures 2 and 3.

Electrostatic coupling to charges on the hot side surface S_{H} produces a quantum-correlation. This appears schematically in Figure 1 as a well W_{H} with two levels connected to an electron reservoir rₕ. As an electron is supplied from the cold-side reservoir r₁ to the cold-side level 1 of the well W_{C1}, accordingly, Coulomb electrostatic coupling between that electron and a charge on the hot side produces a quantum correlation between the cold side electron and such carrier, providing electrostatic interaction U that leads to excitation energy transfer from the hot side to the cold side, thereby elevating the electron in the cold-side well W_{C1} up to higher potential level or state 2, as indicated by the upward arrow portion shown below the symbol U. From this upper state 2, the electron may tunnel, as shown schematically at V, through a potential barrier PB to a matched level 2¹ in a second quantum dot well W_{C2} on its way to a second reservoir r₂ which is at elevated voltage relative to ground, as schematically illustrated at +. The well W_{C2} permits only one level - level 2¹. The two cold-side reservoirs r₁ and r₂ are connected together through an electrical load, so-labeled. Thus, when elections are promoted in the first quantum well W_{C1}, they have the possibility of tunnelling to the second well W_{C2} and then continuing on to do electrical work before ending up in the first reservoir r₁ at ground.

The levels of the hot-side relax to an electron reservoir rₕ, comprising a continuum of excitation levels, wherein the level *a* is coupled to each level in the reservoir with matrix element m₂ and m₃.

Electric fields between an electron on the hot side well W_{H} and an electron on the cold side, couple the product states |*b*>|*1*> and |*a*>|*2*> with coupling *U* such that excitation transfer can occur across the gap g. Level 1 of the well W_{C1}, in turn, relaxes to reservoir r₁ with matrix element m₁ and level 2' of well W_{C2} relaxes to reservoir r₂ with matrix element m₄.

The basic mechanism of the device is that high temperature on the hot side results in excited electrons in the hot-side image, with excitation transferred via electrostatic interaction coupling *U* (between the hot-side charge, which is itself coupled to excited electrons and phonon modes, and the cold-side electron) to promote a cold-side electron from level 1 to level 2 in well W_{C1}.

In summary, thus, an electron reservoir on the cold side supplies an electron to a lower state; and coupling with the hot side causes the electron to be promoted to an excited state, and then the electron proceeds to a second electron reservoir at elevated potential. An electrical load connected between the two reservoirs can be driven from the electrical current caused by the promoted electrons. Such a scheme can work with either electrons or holes (or in principle, both). We have called it a "single carrier converter" since, in accordance with the invention, it is only a single carrier that is promoted at a time, as opposed to photovoltaics, as in the before-mentioned DiMatteo patent, in which electron-hole pairs are created.

### Physical implementations

Figure 2 presents an exploded view of a preferred physical structure of a thermal-electric converter constructed in accordance with the invention to operate in accordance with the methodology thereof as outlined in Figure 1. As before explained, the cold-side surface S_{C} of the device is shown juxtaposed to the hot-side heat emitter surface S_{H} with a small vacuum gap g therebetween. The cold-side converter comprises an array of appropriate semi-conductor small elements or dots, two of which are shown as "Dot 1" and "Dot 2", implemented as by well-known chip technology and in a chip substrate matrix schematically illustrated by S. In practice, these semi-conductor converter dots may assume any desired geometry, such as the rectangular boxes or bar elements shown, supporting and serving as quantum-confined electron energy excitation state wells (W_{C1} and W_{C2}, etc, Figure 1) along (at or near) the surface Sc. Other forms of these semi-conductor elements may include small cylinders or wires, small quantum-well sheets or even molecules. The array of dot elements or the like will be conductor-interconnected, as earlier mentioned by, a network of conductors feeding and outputting electrons to and from the respective elements (reservoir r₁ r₂, etc. in Figure 1) interconnecting the array of dot elements in series and/or in parallel fashion, as appropriate, and also formed into the substrate matrix S of the converter chip side of the device. In the device of Figure 2, moreover, segments of these electron "reservoir" conductors are shown at "Reservoir 1" (r₁ in Figure 1) and at "Reservoir 2" (r₂ in Figure 1) as rectangular cross-section bus portions.

The breakthrough realization, in accordance with the invention, that in an appropriately dimensioned structure, the charge in the quantum dot on the cold side surface S_{C} will couple to a charge on the nearby conductive hot-side surface S_{H}, providing a coupling to surface currents, led to the two-level system model of the invention herein presented.

In the device of Figure 2, the hot side surface S_{H} may accordingly be a simple flat surface as of a metal, semi-metal or highly doped semiconductor. The metal surface has surface charges and the charges act as an effective dipole with zero energy separation that is coupled to thermally excited electrons and phonons. Across the gap g, the cold-side is shown as comprising the before-mentioned two quantum dots on the surface Sc; Dot 1 having two levels (well W_{C1} of Figure 1) and they couple to the hot-side dipole via the electrostatic Coulomb coupling interaction before described. Dot 2 has one level (in well W_{C2} of Figure 1) and it couples to the excited upper level of Dot 1 (state 2 in well W_{C1} of Figure 1) through the tunnelling (V). The lower level of Dot 1 (level 1 in well W_{C1}), as before stated, relaxes to the ground voltage conductor Reservoir 1 (r₁ in Figure 1). The Dot 2 level relaxes to conductor Reservoir 2 which is at the elevated voltage +. Reservoir conductor 1 is shown having a horizontal branch bus portion extending from the vertical leg of the bus conductor in order to couple the lower level of Dot 1, the branch being oriented horizontally to Dot 1 and facing the centre of Dot 1, with a distance. Reservoir conductor 2 is shown parallel to Dot 1 and it runs parallely along the surface S_{C} next to Dot 2, with a distance. Where desired, these dot and conductor elements may also be oriented at other angles, including substantially perpendicular to the plane of the surface S_{C}.

The cold-side structure is repeated as an array over the surface S_{C} as shown in Figure 3, with the Reservoir 1 conductor buses linked together, and the Reservoir 2 conductor buses linked together, and within Reservoirs 1 and 2 connected through the load as in Figure 1.

In a simulated specific structural design of this implementation, we obtained the following exemplary results. The temperature on the hot-side is 1300K, and that on the cold-side, 300K. Dot 1 has *x* x *y* x *z* dimension 120 Å x 100 Å x 100Å and is of the preferred material InSb. The energy separation of the Dot 1 levels is 0.2 eV. The relaxation time of InSb at 0.2eV is l ps. The hot-side is metallic copper, in this equipment, of which relaxation time at 0.2 eV is 0.57 fs. Dot 2 has dimension 50Å x 100Å x 100Å and is horizontally pointing to the top part of Dot 1. (Figure 2 is not drawn to scale). Dot 2 is of material Ga_{0.31}In_{0.69}Sb. The distance between Dot 1 and Dot 2 is 100Å. Reservoir 1 branch is horizontally positioned 50Å away from the centre of Dot 1. Reservoir 2 is located 50Å next to Dot 2. Both reservoirs are preferably made up of n-type InSb doped such that its relaxation time at 0.2 eV is 10 ps. The relaxation time for an n-type InSb with doping level 3 x 10¹⁷cm⁻³ at 0.2 eV is 52 ps, and it is expected that the relaxation time will decrease to zero as the doping increases, since this is the behavior at DC. Therefore there exists a doping level with any desired relaxation time. The surrounding matrix material substrate on the cold side is preferably GaSb.

As before mentioned, the electrostatic interaction between the surface charge and the cold-side dipole is independent of the vacuum gap thickness in the electroquasistatic regime. For thicknesses greater than the wavelength corresponding to the energy separation of cold-side levels 1 and 2 divided by 2π, however, the effects of transverse photons may compromise the device performance. The absorption wavelength corresponding to 0.2 eV is 6.2 µm, and hence the gap should be below about l µm in this case.

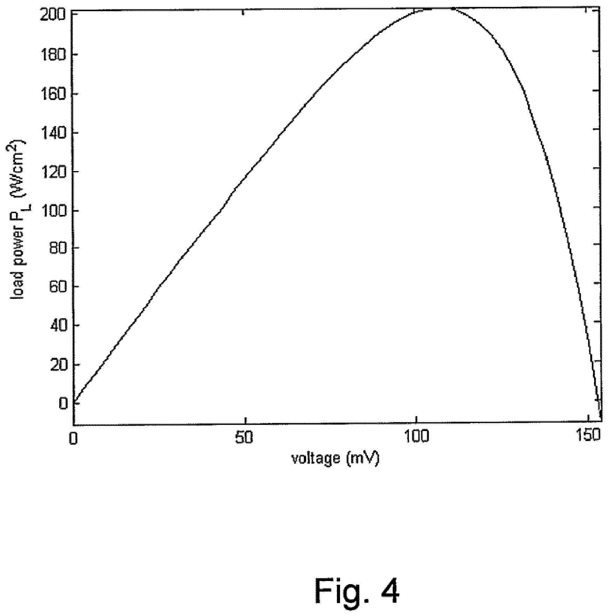

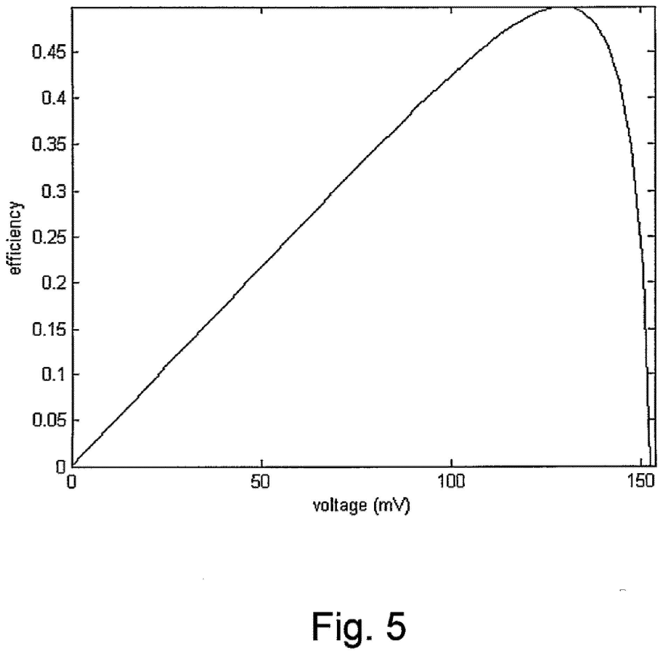

Shown in Figure 4 and Figure 5 are the power on load density and efficiency, respectively, as a function of voltage for the device. An initial estimate for maximum power per unit active area is 202 W/cm² occurring at voltage 107 mV. Figure 5 shows that the maximum efficiency 49.8% occurs at voltage 129 mV.

## Claims

1. A converter having a first-side surface (S_{H}) juxtaposed to a second-side structure (Sc) separated by a gap (g), the first-side surface having electrons for transferring excitation energy across the gap,
the second-side structure comprising at least one second-side converter element, each second-side converter element comprising at least one carrier supplied from at least one first second-side reservoir to at least one first second-side quantum state element being promoted from a first energy level to a second energy level by the transferred excitation energy, **characterised in that** the excitation energy is transferred by electrostatic coupling.

2. A converter according to claim 1 wherein the excitation energy is transferred by Coulomb electrostatic coupling and the at least one carrier is a plurality of electrons or holes.

3. A converter according to claim 1 or claim 2 wherein the excitation energy is transferred by dipole-dipole interaction between the first-side surface and second-side structure.

4. A converter according to any preceding claim wherein the first-side surface comprises dipoles.

5. A converter according to any preceding claim wherein the carrier is an electron associated with the first second-side quantum state element being promoted from a lower energy level to a higher energy level by the transferred excitation energy.

6. A converter according to any preceding claim wherein the carrier is a hole associated with the first second-side quantum state element being promoted from a higher energy level to a lower energy level by the transferred excitation energy.

7. A converter according to any preceding claim wherein the first-side surface is an unstructured flat surface.

8. A converter according to claim 7 wherein the unstructured flat surface is selected from aluminium oxide, metal, semi-metal, or semiconductor.

9. A converter according to any preceding claim wherein only one type carrier charge is promoted at a time.

10. A converter according to any preceding claim wherein the carrier tunnels through at least one second-side potential barrier for reception by at least one second second-side reservoir at elevated voltage.

11. A converter according to any preceding claim wherein the first second-side quantum state element is selected from a well, a dot, a bar, a wire, and one or more sheets.

12. A converter according to any preceding claim wherein the second second-side reservoir is connected to the first second-side reservoir through at least one electrical load.

13. A converter according to any preceding claim wherein the transfer of excitation energy from the first-side surface to the second-side structure transfers heat from the first-side surface to the second-side structure.

14. A converter according to any preceding claim wherein the first-side surface comprises at least one carrier associated with a first-side quantum state element being promoted from a lower energy level to a higher energy level by thermal energy.

15. A converter according to any preceding claim wherein the first-side surface comprises at least one first-side quantum state element with at least one excited energy level supplied by at least one first-side reservoir.

## Patentansprüche

1. Wandler mit einer Oberfläche auf der ersten Seite (S_{H}), die neben einer durch einen Spalt (g) getrennten Struktur auf der zweiten Seite (S_{C}) angeordnet ist, wobei die Oberfläche auf der ersten Seite Elektronen aufweist, die Anregungsenergie über den Spalt übertragen,
wobei die Struktur auf der zweiten Seite mindestens ein Wandlerelement auf der zweiten Seite umfasst, wobei jedes Wandlerelement auf der zweiten Seite mindestens einen Träger umfasst, der von mindestens einem ersten Behälter auf der zweiten Seite zu mindestens einem ersten Quantenzustandselement auf der zweiten Seite zugeführt wird, das durch die übertragene Anregungsenergie von einem ersten Energiepegel auf einen zweiten Energiepegel gefördert wird, **dadurch gekennzeichnet, dass** die Anregungsenergie durch elektrostatisches Koppeln übertragen wird.

2. Wandler nach Anspruch 1, wobei die Anregungsenergie durch elektrostatisches Coulomb-Koppeln übertragen wird und der mindestens eine Träger eine Vielzahl von Elektronen oder Löchern ist.

3. Wandler nach Anspruch 1 oder Anspruch 2, wobei die Anregungsenergie durch Dipol-Dipol-Wechselwirkung zwischen der Oberfläche auf der ersten Seite und der Struktur auf der zweiten Seite übertragen wird.

4. Wandler nach einem der vorangehenden Ansprüche, wobei die Oberfläche auf der ersten Seite Dipole umfasst.

5. Wandler nach einem der vorangehenden Ansprüche, wobei der Träger ein dem ersten Quantenzustandselement auf der zweiten Seite, das durch die übertragene Anregungsenergie von einem niedrigeren Energiepegel auf einen höheren Energiepegel gefördert wird, zugeordnetes Elektron ist.

6. Wandler nach einem der vorangehenden Ansprüche, wobei der Träger ein dem ersten Quantenzustandselement der zweiten Seite, das durch die übertragene Anregungsenergie von einem höheren Energiepegel zu einem niedrigeren Energiepegel gefördert wird, zugeordnetes Loch ist.

7. Wandler nach einem der vorangehenden Ansprüche, wobei die Oberfläche auf der ersten Seite eine unstrukturierte ebene Oberfläche ist.

8. Wandler nach Anspruch 7, wobei die unstrukturierte ebene Oberfläche ausgewählt ist aus Aluminiumoxid, Metall, Halbmetall oder Halbleiter.

9. Wandler nach einem der vorangehenden Ansprüche, wobei zu jeder Zeit Trägerladung nur eines Typs gefördert wird.

10. Wandler nach einem der vorangehenden Ansprüche, wobei der Träger durch mindestens eine potentielle Barriere auf der zweiten Seite gegen den Empfang durch mindestens einen zweiten Behälter auf der zweiten Seite bei erhöhter Spannung tunnelförmig verläuft.

11. Wandler nach einem der vorangehenden Ansprüche, wobei das erste Quantenzustandselement auf der zweiten Seite ausgewählt ist aus einer Vertiefung, einem Punkt, einem Balken, einem Draht und einer oder mehreren Lagen.

12. Wandler nach einem der vorangehenden Ansprüche, wobei der zweite Behälter auf der zweiten Seite durch mindestens eine elektrische Ladung mit dem ersten Behälter auf der zweiten Seite verbunden ist.

13. Wandler nach einem der vorangehenden Ansprüche, wobei die Übertragung von Anregungsenergie von der Oberfläche auf der ersten Seite zur Struktur auf der zweiten Seite Wärme von einer Oberfläche auf der ersten Seite zur Struktur auf der zweiten Seite überträgt.

14. Wandler nach einem der vorangehenden Ansprüche, wobei die Oberfläche auf der ersten Seite mindestens einen einem Quantenzustandselement auf der ersten Seite, das durch Wärmeenergie von einem niedrigeren Energiepegel zu einem höheren Energiepegel gefördert wird, zugeordneten Träger umfasst.

15. Wandler nach einem der vorangehenden Ansprüche, wobei die Oberfläche auf der ersten Seite mindestens ein Quantenzustandselement auf der ersten Seite mit mindestens einem der vorangehenden Anregungsenergiepegel umfasst, der von dem Behälter auf der ersten Seite zugeführt wird.

## Revendications

1. Convertisseur possédant une surface de premier côté (S_{H}) juxtaposée à une structure de deuxième côté (Sc) séparée par un entrefer (g), la surface de premier côté possédant des électrons transférant de l'énergie d'excitation à travers l'entrefer,
la structure de deuxième côté comprenant au moins un élément convertisseur de deuxième côté, chaque élément convertisseur de deuxième côté comprenant au moins un vecteur provenant d'au moins un premier réservoir de deuxième côté à au moins un premier élément d'état quantique de deuxième côté stimulé d'un premier niveau d'énergie à un deuxième niveau d'énergie par l'énergie d'excitation transférée, **caractérisé en ce que** l'énergie d'excitation est transférée par couplage électrostatique.

2. Convertisseur selon la revendication 1, l'énergie d'excitation étant transférée par couplage électrostatique de Coulomb, et au moins un vecteur étant une pluralité d'électrons ou de trous.

3. Convertisseur selon la revendication 1 ou la revendication 2, l'énergie d'excitation étant transférée par interaction dipôle-dipôle entre la surface de premier côté et la structure de deuxième côté.

4. Convertisseur selon une quelconque des revendications précédentes, la surface de premier côté comprenant des dipôles.

5. Convertisseur selon une quelconque des revendications précédentes, le vecteur étant un électron associé avec la stimulation du premier élément d'état quantique de deuxième côté d'un niveau d'énergie inférieur à un niveau d'énergie supérieur par l'énergie d'excitation transférée.

6. Convertisseur selon une quelconque des revendications précédentes, le vecteur étant un trou associé avec la stimulation du premier élément d'état quantique de deuxième côté d'un niveau d'énergie supérieur à un niveau d'énergie inférieur par l'énergie d'excitation transférée.

7. Convertisseur selon une quelconque des revendications précédentes, la surface de premier côté étant une surface plate non structurée.

8. Convertisseur selon la revendication 7, la surface plate non structurée étant sélectionnée parmi de l'oxyde d'aluminium, un métal, un semi-métal, ou un semi-conducteur.

9. Convertisseur selon une quelconque des revendications précédentes, seule une charge d'un vecteur d'un type étant stimulée à la fois.

10. Convertisseur selon une quelconque des revendications précédentes, le vecteur traversant au moins une barrière de potentiel de deuxième côté pour être reçu par au moins un deuxième réservoir de deuxième côté à une tension élevée.

11. Convertisseur selon une quelconque des revendications précédentes, le premier élément d'état quantique de deuxième côté étant sélectionné parmi un puits, un point, une barre, un fil métallique et une ou plusieurs feuilles.

12. Convertisseur selon une quelconque des revendications précédentes, le deuxième réservoir de deuxième côté étant connecté au premier réservoir de deuxième côté par le biais d'au moins une charge électrique.

13. Convertisseur selon une quelconque des revendications précédentes, le transfert d'énergie d'excitation de la surface de premier côté à la structure de deuxième côté transférant de la chaleur de la surface de premier côté à la structure de deuxième côté.

14. Convertisseur selon une quelconque des revendications précédentes, la surface de premier côté comprenant au moins un vecteur associé avec la stimulation d'un élément d'état quantique de premier côté d'un niveau d'énergie inférieur à un niveau d'énergie supérieur par une énergie thermique.

15. Convertisseur selon une quelconque des revendications précédentes, la surface de premier côté comprenant au moins un élément d'état quantique de premier côté avec au moins un niveau d'énergie excité fourni par au moins un réservoir de premier côté.
